# EUROPEAN PATENT APPLICATION

(11) **EP 4 727 273 A1**
(43) Date of publication of application: **15.04.2026**
(21) Application number: 24835169.4
(22) Date of filing: 30.05.2024
(51) Int. Cl.: H05K 5/02

(54) **MOUNTING ASSEMBLY FOR MIDDLE BEZEL, AND ELECTRONIC DEVICE**

(30) Priority: 06.07.2023 CN 202310830850
(71) Applicant: ZTE CORPORATION, Shenzhen, Guangdong 518057 (CN)
(72) Inventor: CHEN, Liang, Shenzhen, Guangdong 518057 (CN)
(74) Representative: Carangelo, Pierluigi
(86) International application number: PCT/CN2024/096463
(87) International publication number: WO 2025/007686

(57) **Abstract**

The present disclosure relates to the technical field of electronic products. Provided are a mounting assembly for a middle bezel, and an electronic device. The mounting assembly for a middle bezel comprises a mounting member and an elastic member, wherein part of the mounting member is accommodated in an accommodating recess of a middle bezel and is used for mounting a key of the middle bezel; and when the mounting member is accommodated in the accommodating recess, at least part of the elastic member is elastically pressed between the mounting member and a side wall of the accommodating recess. The mounting assembly provided in the present disclosure can securely mount the key in the middle bezel without shaking, also has a low processing requirement for the size of the middle bezel, and is convenient to assemble and disassemble.

## Description

### Cross-Reference to Related Application

The present disclosure claims priority to Chinese Patent Application CN202310830850.3, filed on July 6, 2023 and entitled "Mounting Assembly for Middle Bezel, and Electronic Device", the disclosure of which is hereby incorporated by reference in its entirety.

### Technical Field

The present disclosure relates to the technical field of electronic products, and in particular, to a mounting assembly for a middle bezel, and an electronic device.

### Background

With the development of electronic technologies, requirements for electronic products such as mobile phones, tablets, and e-readers are becoming increasingly stringent. Among these requirements, waterproof performance has become a fundamental requirement. During the assembly of electronic products, the method of assembling keys from the inside out is not suitable for waterproof products. At present, the method of assembling keys from the outside in is basically adopted. According to the structure of keys, the keys may be divided into two types: an integrated key (the key is a single integral piece) and a split-type key (the split-type key usually includes a key and a mounting member for mounting the key).

Integral keys are assembled by means of key + Thermoplastic Polyurethane (TPU) dispensing and bonding. This assembly method has the following defects. 1) The assembly method has high requirements for the control of adhesive dosage and adhesive storage. Insufficient dispensing volume, use of expired adhesive, or failure to set the adhesive according to specified parameters will all lead to insufficient pulling force and the risk of key detachment; 2) During assembly, the key may get stuck in the mounting slot and fail to fully reset, resulting in poor hand feel; and 3) The key has a large wobble amplitude.

The split-type key is usually assembled by combining a barb on the key with a small metal sheet. This assembly method has the following defects. 1) The small metal sheet is fixed to the middle bezel (metal material) by friction. The coefficient of friction between the two metals is relatively low, leading to unstable fixation and easy detachment of the small metal sheet. 2) The small metal sheet itself wobbles, which makes it impossible to securely lock the key, resulting in obvious key wobble.

### Summary

Embodiments of the present disclosure provide a mounting assembly for a middle bezel, and an electronic device, which solve the technical problems such as insecure mounting of keys and susceptibility to wobble.

In a first aspect, the embodiments of the present disclosure provide a mounting assembly for a middle bezel, including a mounting member and an elastic member.

Part of the mounting member is accommodated in an accommodating recess of the middle bezel and is used for mounting a key of the middle bezel.

When the mounting member is accommodated in the accommodating recess, at least part of the elastic member is elastically pressed between the mounting member and a recess side wall of the accommodating recess.

In a second aspect, the embodiments of the present disclosure further provide an electronic device, including a middle bezel, a key, and mounting assemblies.

The middle bezel has a mounting groove and accommodating recesses, and the mounting groove communicates with the accommodating recesses.

The key is movably mounted in the mounting groove, part of the key is accommodated in the mounting groove, and the other part of the key extends out of the mounting groove.

Each of the mounting assemblies is the above-mentioned mounting assembly, part of the mounting assembly is accommodated in a corresponding one of the accommodating recesses, and the other part of the mounting assembly extends into the mounting groove to abut against the key, and is configured to restrict the key from moving towards a groove opening of the mounting groove.

### Brief Description of the Drawings

In order to more clearly illustrate the embodiments of the present disclosure or the technical solutions in the related art, the drawings used in the description of the embodiments or the related art will be briefly described below. It is apparent that the drawings described below are only some embodiments of the present disclosure. Other drawings may further be obtained by those skilled in the art according to the structures shown in these drawings without creative efforts.
Fig. 1 is a schematic structural diagram of an electronic device according to an embodiment of the present disclosure from one perspective.
Fig. 2 is a schematic structural diagram of an electronic device according to an embodiment of the present disclosure from another perspective.
Fig. 3 is an enlarged partial view at position A in Fig. 2.
Fig. 4 is a cross-sectional view of an electronic device according to an embodiment of the present disclosure.
Fig. 5 is an enlarged partial view at position B in Fig. 4.
Fig. 6 is a schematic structural diagram of a middle bezel according to an embodiment of the present disclosure.
Fig. 7 is an enlarged partial view at position C in Fig. 6.
Fig. 8 is a schematic structural diagram of a mounting assembly according to an embodiment of the present disclosure from one perspective.
Fig. 9 is a bottom view of a mounting assembly according to an embodiment of the present disclosure.
Fig. 10 is a schematic structural diagram of a mounting member according to an embodiment of the present disclosure from one perspective.
Fig. 11 is a schematic structural diagram of a mounting member according to an embodiment of the present disclosure from another one perspective.
Fig. 12 is a schematic structural diagram of a key according to an embodiment of the present disclosure.

### Illustration of reference signs:

100, Middle bezel; 101, Mounting groove; 102, Accommodating recess; 1021, First recess side wall; 1022, Second recess side wall; 200, Key; 201, Pressing portion; 202, Second abutting portion; 203, Connecting portion; 300, Mounting assembly; 10, Mounting member; 11, Mounting body; 111, First side surface; 112, Third side surface; 12, First abutting portion; 121, Second side surface; 13, Annular groove; 131, First groove body; 132, Second groove body; 20, Elastic member; 21, Inclined surface.

The realization of the objectives, functional features, and advantages of the present disclosure will be further described in conjunction with embodiments and with reference to the drawings.

### Detailed Description of the Embodiments

The technical solutions in the embodiments of the present disclosure will be clearly and completely described below in conjunction with the drawings in the embodiments of the present disclosure. It is apparent that the described embodiments are only part of the embodiments of the present disclosure but not all the embodiments. All other embodiments obtained by those skilled in the art on the basis of the embodiments in the present disclosure without creative work shall fall within the scope of protection of the present disclosure.

It is to be noted that all directional indications (such as up, down, left, right, front, back, and the like) in the embodiments of the present disclosure are only used to explain the relative positional relationships and movement between various components under a specific posture. If the specific posture changes, the directional indications are changed accordingly.

It is further to be noted that when an element is referred to as being "fixed to" or "disposed on" another element, the element may be directly on the other element or there may also be an intermediate element at the same time. When an element is referred to as being "connected" to another element, the element may be directly connected to the other element or there may also be an intermediate element at the same time.

In addition, "first", "second", and the like involved in the present disclosure are used for descriptive purposes only, and cannot be understood as indicating or implying relative significance or implicitly indicating the number of indicated technical features. Therefore, the features defined with "first" and "second" may explicitly or implicitly include at least one of the features. In addition, the technical solutions between the various embodiments may be combined with each other, but must be implementable by those skilled in the art, and when the combination of the technical solutions is contradictory or impossible to implement, it should be considered that the combination of the technical solutions does not exist and is not within the scope of protection claimed in the present disclosure.

During key assembly, both integrated keys and split-type keys may have more or less defects, such as insecure key mounting and excessive key wobble. In view of this, the present disclosure provides a mounting assembly for a middle bezel, and an electronic device. The mounting assembly may securely mount the key to the middle bezel without excessive wobble, while having a low processing requirement for the dimensions of the middle bezel.

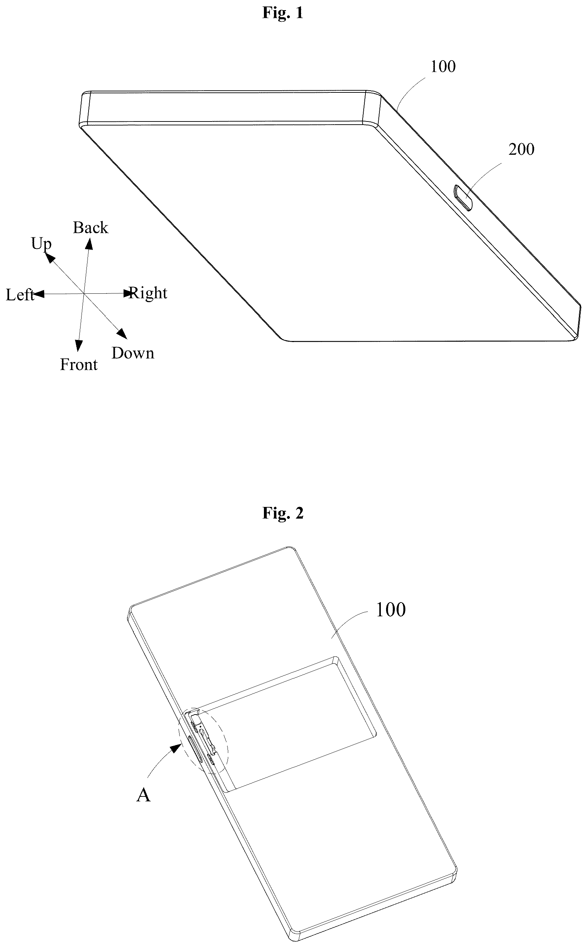

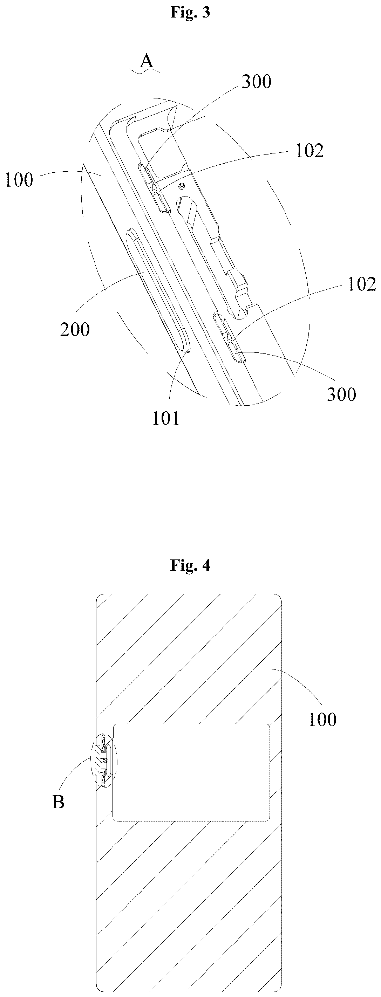

As shown in Fig. 1 to Fig. 7, an electronic device provided by the embodiments of the present disclosure includes a middle bezel 100, a key 200, and mounting assemblies 300. The middle bezel 100 has a mounting groove 101 and accommodating recesses 102, and the mounting groove 101 communicates with the accommodating recesses 102. The key 200 is movably mounted in the mounting groove 101, part of the key 200 is accommodated in the mounting groove 101, and the other part of the key 200 extends out of the mounting groove 101. Part of the mounting assembly 300 is accommodated in a corresponding accommodating recess 102, and the other part of the mounting assembly 300 extends into the mounting groove 101 to abut against the key 200, and is configured to restrict the key 200 from moving towards a groove opening of the mounting groove 101. In a specific application, the end of the key 200 away from the groove opening of the mounting groove 101 is connected to a switch of the electronic device, and the switch applies an elastic force to the key 200 in the direction toward the groove opening of the mounting groove 101, thereby causing the key 200 to move in the direction toward the groove opening of the mounting groove 101 and then abut against the mounting assemblies 300. When the key 200 abuts against the mounting assemblies 300, the mounting assemblies 300 generate resistance to the key 200 in a direction toward the switch, and the key 200 is securely mounted in the mounting groove 101 under the action of the elastic force and the resistance. Further, at least when the key 200 abuts against the mounting assemblies 300, the end of the key 200 away from the switch extends out of the mounting groove 101, that is, the key 200 is provided in a protruding manner to facilitate pressing.

Through the adoption of the above technical solution, by providing the mounting groove 101 and the accommodating recesses 102, the key 200 is movably mounted in the mounting groove 101, and the mounting assemblies 300 are mounted in the accommodating recesses 102. By communicating the mounting groove 101 with the accommodating recesses 102, when the key 200 moves in the direction toward the groove opening of the mounting groove 101 under the action of the switch, the key 200 can abut against the mounting assemblies 300, thereby restricting the key 200 from moving towards the groove opening of the mounting groove 101 and further preventing the key 200 from detachment from the mounting groove 101. Furthermore, under the combined action of the mounting assembles 300 and the switch, the key 200 is subjected to the combined action of resistance and elastic force in opposite directions, thereby preventing excessive wobble.

As an implementation, the electronic device includes, but is not limited to, a mobile phone, a tablet, a laptop, and an e-reader.

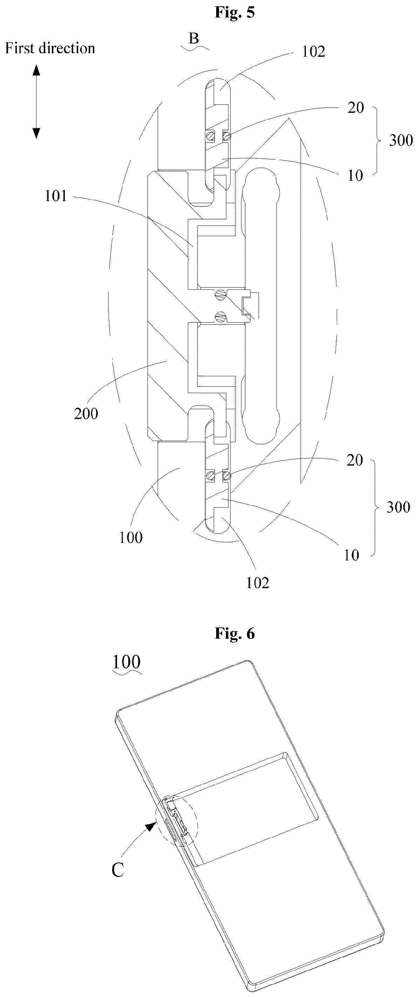

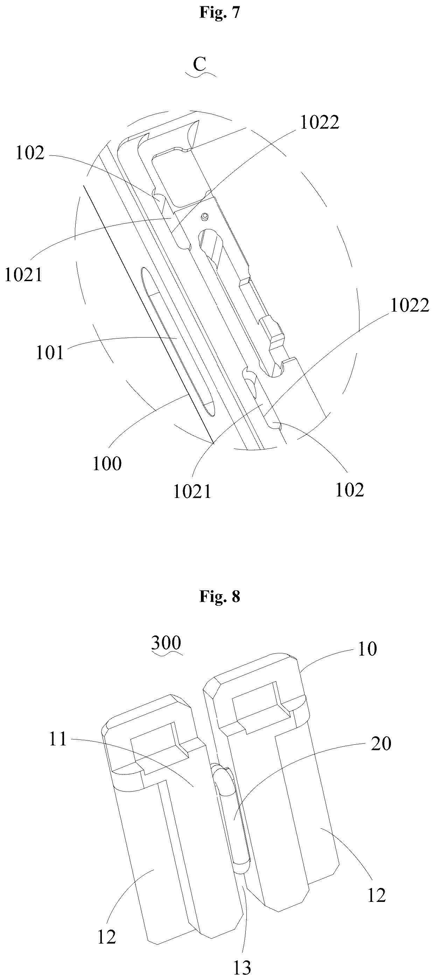

Referring to Fig. 5 and Fig. 8, the mounting assembly 300 for the middle bezel 100 provided in the embodiments of the present disclosure includes a mounting member 10 and an elastic member 20. Part of the mounting member 10 is accommodated in the accommodating recess 102 of the middle bezel 100 and is used for mounting the key 200 of the middle bezel 100. When the mounting member 10 is accommodated in the accommodating recess 102, at least part of the elastic member 20 is elastically pressed between the mounting member 10 and a recess side wall of the accommodating recess 102. By providing the mounting member 10 for mounting the key 200 of the middle bezel 100, that is, the mounting member 10 abuts against the key 200 to prevent the key 200 from detachment from the middle bezel 100, and in combination with the elastic force provided by the switch, the key 200 is securely mounted without wobble. By providing the elastic member 20, when the mounting member 10 is accommodated in the accommodating recess 102, the elastic member 20 is elastically pressed between the mounting member 10 and the recess side wall of the accommodating recess 102. On the one hand, the mounting member 10 is securely accommodated in the accommodating recess 102, thereby avoiding wobble of the key 200 due to wobble of the mounting member 10. On the other hand, since the elastic member 20 is elastically pressed between the mounting member 10 and the recess side wall of the accommodating recess 102, the dimensions of the accommodating recess 102 do not need to strictly match the outer profile of the mounting member 10, thereby reducing the dimensional requirement for the accommodating recess 102, that is, reducing the processing requirement for the dimensions of the middle bezel 100 to achieve strong tolerance capability, a significantly improved yield rate of the middle bezel 100, and a substantial cost reduction. In yet another aspect, due to the elasticity of the elastic member 20, the mounting (installation) of the mounting assembly 300 into the accommodating recess 102 or removal from the accommodating recess 102 is facilitated. Therefore, the mounting assembly 300 provided in the embodiments of the present disclosure can securely mount the key 200 in the middle bezel 100 without wobble, while having a low processing requirement for the dimensions of the middle bezel 100 and facilitating the assembly and disassembly of the mounting assembly 300.

As an implementation, referring to Fig. 5 and Fig. 8, the mounting member 10 includes a mounting body 11 and at least one first abutting portion 12 connected to the mounting body 11, the at least one first abutting portion 12 being configured to abut against the key 200 of the middle bezel 100. The elastic member 20 is connected to the mounting body 11, and when the mounting member 10 is accommodated in the accommodating recess 102, at least part of the elastic member 20 is elastically pressed between the mounting body 11 and the recess side wall of the accommodating recess 102. The structure is simple and facilitates manufacturing. Of course, in a specific application, as an alternative implementation, the elastic member 20 may alternatively not be connected to the mounting body 11. For example, the elastic member 20 is connected to the recess side wall of the accommodating recess 102, or the elastic member 20 is disposed separately, and when the mounting member 10 is accommodated in the accommodating recess 102, the elastic member 20 is pressed between the mounting member 10 and the recess side wall of the accommodating recess 102.

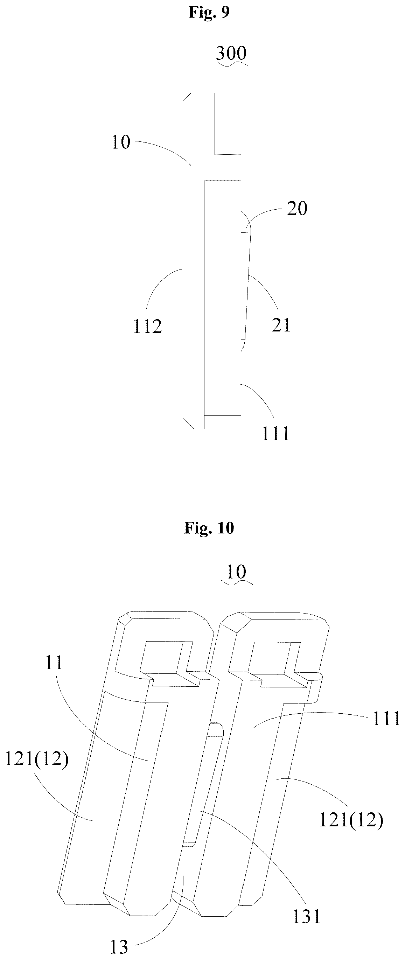

As an implementation, referring to Fig. 5, Fig. 7, Fig. 9, and Fig. 10, the mounting body 11 is provided with a first side surface 111, and when the mounting member 10 is accommodated in the accommodating recess 102, at least part of the elastic member 20 protrudes from or is flush with the first side surface 111 and is pressed against the recess side wall of the accommodating recess 102. The at least one first abutting portion 12 is provided with a second side surface 121, the second side surface 121 is configured to abut against the key 200 of the middle bezel 100, and the first side surface 111 and the second side surface 121 are disposed on the same side. By providing the second side surface 121 to abut against the key 200, at least part of the elastic member 20, which protrudes from or is flush with the first side surface 111, is elastically pressed against the recess side wall of the accommodating recess 102, and the first side surface 111 and the second side surface 121 are disposed on the same side, so that a third side surface 112 of the mounting body 11 described below abuts against the other part of the recess side wall of the accommodating recess 102 when the mounting member 10 is accommodated in the accommodating recess 102. For ease of description, the recess side wall of the accommodating recess 102 elastically pressed by at least part of the elastic member 20, which protrudes from or is flush with the first side surface 111, is defined as a first recess side wall 1021, and a recess side wall of the accommodating recess 102 against which the third side surface 112 is pressed tightly is defined as a second recess side wall 1022. Regardless of whether the key 200 abuts against the at least one first abutting portion 12, the third side surface 112 of the mounting body 11 is pressed tightly against the second recess side wall 1022, and the mounting member 10 is securely mounted without being affected by whether the key 200 abuts the at least one first abutting portion 12, thereby forming a unilateral interference that is less affected by other factors. The second recess side wall 1022 and the first recess side wall 1021 are disposed opposite to each other at an interval. In a specific application, the elastic member 20 may be configured to provide a unilateral interference of 0.05 mm-0.1 mm. In this way, loosening of the elastic member 20 and difficulty in mounting the mounting assembly 300 into the accommodating recess 102 may be prevented.

As an implementation, referring to Fig. 5, Fig. 7, and Fig. 9, the elastic member 20 has an inclined surface 21. The inclined surface 21 extends obliquely in a direction from the top of the mounting member 10 to the bottom of the mounting member 10, gradually approaching the first side surface 111. Specifically, at least the elastic member 20 located at the top of the mounting member 10 is elastically pressed against the first recess side wall 1021. Through this arrangement, the insertion of the mounting assembly 300 into the accommodating recess 102 is facilitated, and the dimensional requirements for the processing accuracy of the accommodating recess 102 and the mold forming accuracy of the mounting assembly 300 are reduced. The top of the mounting member 10 refers to the end corresponding to a recess opening of the accommodating recess 102 when the mounting member 10 is accommodated in the accommodating recess 102, and the bottom of the mounting member 10 refers to the end corresponding to a recess bottom wall of the accommodating recess 102 when the mounting member 10 is accommodated in the accommodating recess 102. Of course, in a specific application, as an alternative implementation, the elastic member 20 may alternatively not be provided with the inclined surface 21.

As an implementation, the elastic member 20 is annular, the elastic member 20 is sleeved on the periphery of the mounting body 11 in a height direction of the mounting member 10, and at least part of the elastic member 20 protrudes from the first side surface 111. Through this arrangement, in the assembly process, the elastic member 20 can be directly sleeved on the periphery of the mounting body 11 in the height direction of the mounting member 10, and the assembly is convenient and quick. Of course, in a specific application, as an alternative implementation, the elastic member 20 may alternatively be disposed in a non-annular shape, for example, in a strip shape or a block shape. When adopting the solution, the elastic member 20 may be mounted on the first side surface 111. The height direction of the mounting member 10 is a direction from the bottom to the top of the mounting member 10.

As an implementation, referring to Fig. 8, the mounting body 11 is provided with an annular groove 13 in the height direction, and the elastic member 20 is accommodated in the annular groove 13. In this way, the stability of assembly of the elastic member 20 on the mounting member 10 is improved. It is understandable that, in other embodiments, the mounting body 11 is not provided with the annular groove 13, and the elastic member 20 may be directly sleeved on an outer surface of the mounting body 11.

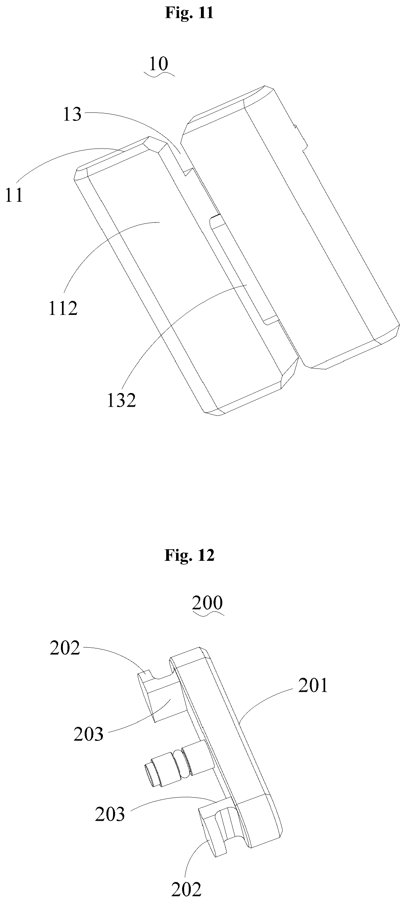

As an implementation, referring to Fig. 7, and Fig. 9 to Fig. 11, the mounting body 11 is further provided with the third side surface 112 disposed opposite to the first side surface 111. The annular groove 13 includes a first groove body 131 and a second groove body 132. A groove opening of the first groove body 131 is formed in the first side surface 111, and a groove opening of the second groove body 132 is formed in the third side surface 112. A cross-sectional diameter of the elastic member 20 is greater than a groove depth of the first groove body 131 and less than or equal to a groove depth of the second groove body 132. Through this arrangement, part of the elastic member 20 protrudes from the first side surface 111, and when the mounting assembly 300 is accommodated in the accommodating recess 102, the elastic member 20 can be elastically pressed against the first recess side wall 1021, and the second side surface of the mounting body 11 can abut against the second recess side wall 1022.

As an implementation, the groove depth of the first groove body 131 gradually increases in the direction from the top of the mounting member 10 to the bottom of the mounting member 10. Through this arrangement, when the elastic member 20 is accommodated in the annular groove 13, the portion located in the first groove body 131 can form the inclined surface 21. Of course, in a specific application, as an alternative implementation, the groove depth of the first groove body 131 is the same in the direction from the top of the mounting member 10 to the bottom of the mounting member 10. The inclined surface 21 may alternatively be directly disposed on the elastic member 20.

As an implementation, the mounting member 10 includes two first abutting portions 12. The two first abutting portions 12 are connected to opposite sides of the mounting body 11, and the mounting member 10 is of a symmetrical structure. Through this arrangement, mounting and manufacturing of the mounting member 10 are facilitated, and the versatility of the mounting member 10 is improved. Specifically, the mounting member 10 may be symmetrically disposed with the portion corresponding to the annular groove 13 as a central axis. Of course, in a specific application, as an alternative implementation, the mounting member 10 may alternatively include one first abutting portion 12.

As an implementation, the mounting member 10 is made of a rigid plastic material, and the elastic member 20 is made of a soft elastic material. The mounting member 10 is made of a rigid plastic material, so that the mounting member 10 has sufficient strength to abut against the key 200. The elastic member 20 is made of a soft elastic material, so that the elastic member 20 has elasticity.

As an implementation, the rigid plastic material includes at least one of Acrylonitrile Butadiene Styrene (ABS) or Polycarbonate (PC). The soft elastic material includes at least one of hydrogenated nitrile butadiene rubber, nitrile butadiene rubber, silicone rubber, fluorine rubber, fluorosilicone rubber, or butyl rubber. In a specific application, the mounting member 10 and the elastic member 20 may be colored consistently with the middle bezel 100 (both are black), which may improve the secondary appearance refinement of the electronic device.

As an implementation, the mounting assembly 300 is integrally molded by the elastic member 20 and the mounting member 10 through a liquid silicone injection molding process. Manufacturing is quick and time is saved.

As an implementation, referring to Fig. 5, the number of the mounting assemblies 300 and the number of the accommodating recesses 102 are both two. The two accommodating recesses 102 are distributed at an interval in a first direction, and the mounting groove 101 is disposed between the two accommodating recesses 102 and communicates with the two accommodating recesses 102. The two mounting assemblies 300 are provided in a one-to-one correspondence with the two accommodating recesses 102. In this way, both sides of the key 200 in the first direction are mounted by the two mounting assemblies 300, so that the key 200 is more stably mounted without wobble. Here, the first direction is a length direction of the key 200.

As an implementation, the two accommodating recesses 102 are symmetrically disposed on both sides of the mounting groove 101, so that the two mounting assemblies 300 are symmetrically located on both sides of the key 200. Through this arrangement, the smoothness of mounting of the key 200 is improved.

As an implementation, referring to Fig. 5, Fig. 8, and Fig. 12, the key 200 includes a pressing portion 201, two second abutting portions 202, and two connecting portions 203. The pressing portion 201 extends in the first direction, the two second abutting portions 202 are disposed at an interval in the first direction, and the two second abutting portions 202 are both disposed on the side of the pressing portion 201 facing the groove bottom wall of the mounting groove 101. One connecting portion 203 is connected between each second abutting portion 202 and the pressing portion 201, and one first abutting portion 12 is disposed between each second abutting portion 202 and the pressing portion 201. Through this arrangement, the second abutting portion 202 abuts against the at least one first abutting portion 12, and when the second abutting portion 202 abuts against the at least one first abutting portion 12, the at least one first abutting portion 12 applies resistance to the second abutting portion 202 in the direction toward the switch.

As an implementation, the groove opening of the mounting groove 101 is opened in a side portion of the middle bezel 100, and the mounting groove 101 extends in a width direction or a length direction of the middle bezel 100. Specifically, the side of the electronic device provided with a display screen is defined as a front portion, the side disposed opposite to the front portion is defined as a rear portion, and the portions that connect the front portion and the rear portion are side portions. The side portions may be classified into a top side, a bottom side, a left side, and a right side. When the groove opening of the mounting groove 101 is formed in the top side or the bottom side of the middle bezel 100, the mounting groove 101 extends in the width direction of the middle bezel 100, and the above first direction is the width direction of the middle bezel 100. When the groove opening of the mounting groove 101 is formed in the left side or the right side of the middle bezel 100, the mounting groove 101 extends in the length direction of the middle bezel 100, and the above first direction is the length direction of the middle bezel 100.

As an implementation, the recess opening of the accommodating recess 102 is formed in the rear portion of the middle bezel 100, and the accommodating recess 102 extends in a thickness direction of the middle bezel 100.

The above are merely exemplary embodiments of the present disclosure, and are not intended to limit the scope of the present disclosure. Any equivalent structural transformations made based on the inventive concept of the present disclosure by using the contents of the specification of the present disclosure and the drawings, whether directly or indirectly applied to other related technical fields, shall fall within the scope of protection of the present disclosure.

## Claims

1. A mounting assembly for a middle bezel, wherein the mounting assembly comprises:
a mounting member, wherein part of the mounting member is accommodated in an accommodating recess of the middle bezel and is used for mounting a key of the middle bezel; and
an elastic member, wherein when the mounting member is accommodated in the accommodating recess, at least part of the elastic member is elastically pressed between the mounting member and a recess side wall of the accommodating recess.

2. The mounting assembly according to claim 1, wherein the mounting member comprises a mounting body and at least one first abutting portion connected to the mounting body, the at least one first abutting portion being configured to abut against the key of the middle bezel; and
the elastic member is connected to the mounting body, and when the mounting member is accommodated in the accommodating recess, at least part of the elastic member is elastically pressed between the mounting body and the recess side wall of the accommodating recess.

3. The mounting assembly according to claim 2, wherein the mounting body is provided with a first side surface, and when the mounting member is accommodated in the accommodating recess, at least part of the elastic member protrudes from or is flush with the first side surface and is pressed against the recess side wall of the accommodating recess; and
the at least one first abutting portion is provided with a second side surface, wherein the second side surface is configured to abut against the key of the middle bezel, and the first side surface and the second side surface are disposed on a same side.

4. The mounting assembly according to claim 3, wherein the elastic member has an inclined surface; and
the inclined surface extends obliquely in a direction from the top of the mounting member to the bottom of the mounting member, gradually approaching the first side surface.

5. The mounting assembly according to claim 3, wherein the elastic member is annular, the elastic member is sleeved on the periphery of the mounting body in a height direction of the mounting member, and at least part of the elastic member protrudes from the first side surface.

6. The mounting assembly according to claim 5, wherein the mounting body is further provided with a third side surface disposed opposite the first side surface;
the mounting body is provided with an annular groove in the height direction, and the elastic member is accommodated in the annular groove;
the annular groove comprises a first groove body and a second groove body, wherein a groove opening of the first groove body is formed in the first side surface, and a groove opening of the second groove body is formed in the third side surface; and
a cross-sectional diameter of the elastic member is greater than a groove depth of the first groove body and less than or equal to a groove depth of the second groove body.

7. The mounting assembly according to claim 6, wherein the groove depth of the first groove body gradually increases in a direction from the top of the mounting member to the bottom of the mounting member.

8. The mounting assembly according to any one of claims 2 to 7, wherein the mounting member comprises two first abutting portions, wherein the two first abutting portions are connected to opposite sides of the mounting body, and the mounting member is of a symmetrical structure.

9. The mounting assembly according to any one of claims 1 to 7, wherein the mounting member is made of a rigid plastic material and the elastic member is made of a soft elastic material.

10. The mounting assembly according to claim 9, wherein the rigid plastic material comprises at least one of Acrylonitrile Butadiene Styrene, ABS, or Polycarbonate, PC; and
the soft elastic material comprises at least one of hydrogenated nitrile butadiene rubber, nitrile butadiene rubber, silicone rubber, fluorine rubber, fluorosilicone rubber, or butyl rubber.

11. An electronic device, comprising:
a middle bezel, wherein the middle bezel has a mounting groove and accommodating recesses, and the mounting groove communicates with the accommodating recesses;
a key, wherein the key is movably mounted in the mounting groove, part of the key is accommodated in the mounting groove, and the other part of the key extends out of the mounting groove; and
mounting assemblies, each of which is the mounting assembly according to any one of claims 1 to 10, wherein part of the mounting assembly is accommodated in a corresponding accommodating recess, and the other part of the mounting assembly extends into the mounting groove to abut against the key, and is configured to restrict the key from moving towards a groove opening of the mounting groove.

12. The electronic device according to claim 11, wherein the number of the mounting assemblies and the number of the accommodating recesses are both two;
the two accommodating recesses are distributed at an interval in a first direction, and the mounting groove is disposed between the two accommodating recesses and communicates with the two accommodating recesses; and
the two mounting assemblies are provided in a one-to-one correspondence with the two accommodating recesses.

13. The electronic device according to claim 12, wherein the two accommodating recesses are symmetrically disposed on both sides of the mounting groove, so that the two mounting assemblies are symmetrically located on both sides of the key.
